# EUROPEAN PATENT APPLICATION

(11) **EP 4 831 772 A1**
(43) Date of publication of application: **28.10.2026**
(21) Application number: 26168105.0
(22) Date of filing: 26.03.2026
(51) Int. Cl.: G06F 1/188, A47B 96/02, G06F 1/187, H05K 7/14, H05K 9/00

(54) **A SCRATCH PROTECTION GUARD**

(30) Priority: 02.04.2025 IN 202511032695; 25.03.2026 US 202619577774
(71) Applicant: Vertiv Corporation, Westerville, OH 43082 (US)
(72) Inventor: Khandelwal, Adarsh, Westerville, 43082 (US); Jethva, Kishan Jaysukh-Bhai, Westerville, 43082 (US)
(74) Representative: Cousens, Nico

(57) **Abstract**

The present disclosure relates to a scratch protection guard **100, 400** for sliding components. The scratch protection guard comprises a mushroom-shaped body **102, 402** configured to fit in a housing shelf, preventing direct contact between a sliding component and the housing shelf to minimize surface damage. A metallic contact element **104, 404** integrated with the mushroom-shaped body **102, 402** engages both the sliding component and the housing shelf, ensuring continuous electrical grounding to reduce electromagnetic interference.

## Description

### TECHNICAL FIELD

The present disclosure relates to protection elements for use in electro-mechanical fixtures. More specifically, the present disclosure relates to a scratch protection guard for housing shelves and sliding components.

### BACKGROUND

Electro-mechanical fixtures are assemblies used to support and guide sliding components within equipment housings and enclosures. Such fixtures typically include housing shelves configured to receive sliding components such as rack-mounted modules, electronic assemblies, or mechanical subunits that are inserted into and removed from the housing during installation, servicing, or replacement. The sliding components are arranged to move relative to the housing shelves along defined contact interfaces within the fixture.

Protection elements may be incorporated into electro-mechanical fixtures to interface with housing shelves and sliding components. These protection elements are configured to be positioned on or within the housing shelves and to cooperate with the movement of the sliding components relative to the shelves. The protection elements may form part of the housing structure and are designed to function in conjunction with the mechanical and electrical characteristics of the electro-mechanical fixture.

### SUMMARY OF THE DISCLOSURE

This summary is provided to introduce aspects related to a scratch protection guard. The scratch protection guard is configured for use with housing shelves and sliding components in electro-mechanical fixtures. The guard integrates a body portion positioned at an interface between a housing shelf and a sliding component, together with a conductive contact element arranged to engage both the sliding component and the housing shelf. The configuration enables controlled mechanical interaction during sliding movement while maintaining electrical continuity between the components. The arrangement supports compact integration within standard housing shelves, accommodates repeated insertion and removal of sliding components, and provides compatibility with a range of enclosure and component configurations. In doing so, the disclosure supports durable operation of electro-mechanical fixtures while maintaining consistent mechanical and electrical interfacing.

A scratch protection guard is disclosed. A scratch protection guard includes a mushroom-shaped body to fit in a housing shelf. Further, the scratch protection guard includes a section of the mushroom-shaped body surfaces on the housing shelf to prevent direct contact between the housing shelf and a sliding component made to slide over the housing shelf. Further, the scratch protection guard includes a metallic contact element integrated with the mushroom-shaped body. The metallic contact element comprises a first portion and a second portion. The first portion engages with the sliding component and the second portion engages with the housing shelf to facilitate electrical grounding for the sliding component.

Other aspects and advantages of the disclosure will become apparent from the following description, taken in conjunction with the accompanying drawings, illustrating by way of example the principles of the disclosure.

### BRIEF DESCRIPTION OF THE DRAWINGS

The accompanying figures of the drawing, which are included to provide a further understanding of general aspects of the system/method, are incorporated in and constitute a part of this specification. These illustrative aspects of the system/method, and together with the detailed description, explain the principles of the system. No attempt is made to show structural details in more detail than is necessary for a fundamental understanding of the system and various ways in which it is practiced. The following figures of the drawing include:
**FIG. 1** illustrates a front view of a scratch protection guard;
**FIG. 2** illustrates a sectional view of the scratch protection guard;
**FIG. 3A** illustrates a perspective view of a housing shelf having the scratch protection guard installed;
**FIG. 3B** illustrates a sectional view of the sliding component fixed on the housing shelf with the scratch protection guard;
**FIG. 4A** illustrates a sectional view of the sliding component fixed on the housing shelf with the scratch protection guard;
**FIG. 4B** illustrates a sectional view of the another scratch protection guard; and
**FIG. 5** illustrates a sectional view of the sliding component fixed on the housing shelf with the another scratch protection guard.

In the appended figures, similar components and/or features may have the same numerical reference label. Further, various components of the same type may be distinguished by following the reference label with a letter. If only the first numerical reference label is used in the specification, the description is applicable to any one of the similar components and/or features having the same first numerical reference label irrespective of the suffix.

### DESCRIPTION OF THE DISCLOSURE

Illustrative embodiments are described with reference to the accompanying drawings. Wherever convenient, the same reference numbers are used throughout the drawings to refer to the same or like parts. While examples and features of disclosed principles are described herein, modifications, adaptations, and other implementations are possible without departing from the scope of the disclosed embodiments. It is intended that the following detailed description be considered as exemplary only, with the true scope being indicated by the following claims.

Conventional electro-mechanical fixtures used in industrial and electronic installations typically employ metallic housing shelves to support sliding components. In such fixtures, sliding components are guided along contact surfaces defined by the housing shelves during insertion and removal. The interaction between the sliding components and the metallic shelves occurs repeatedly over the operational life of the fixture and is governed by dimensional tolerances, surface finishes, and alignment characteristics of the shelf and component interfaces. In many existing arrangements, the housing shelves simultaneously serve as mechanical support structures and electrical reference surfaces for the sliding components.

The present disclosure introduces a scratch protection guard configured to be positioned within a housing shelf at an interface between the housing shelf and a sliding component. The scratch protection guard includes a body portion that surfaces on the housing shelf to form a defined contact interface with the sliding component, and a conductive contact element integrated with the body portion. The conductive contact element is arranged to engage both the sliding component and the housing shelf, thereby establishing an electrical connection while the sliding component moves relative to the housing shelf.

By integrating the body portion and the conductive contact element into a compact structure sized to fit within standard housing shelves, the scratch protection guard supports repeated sliding movement of components while maintaining consistent mechanical interfacing and electrical continuity. The configuration is compatible with a range of electro-mechanical fixtures and sliding component form factors, and may be implemented without modification to existing enclosure architectures.

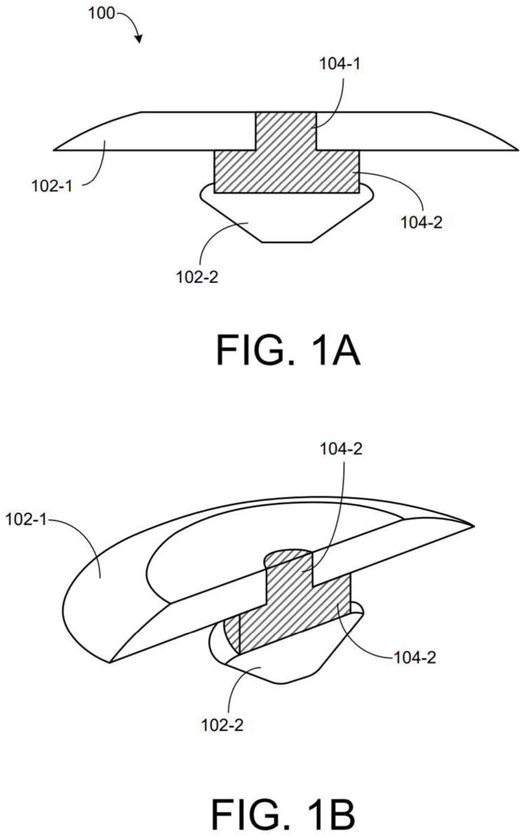

**FIGS. 1A** and **1B** illustrate a front view and a sectional view of a scratch protection guard **100,** respectively. The scratch protection guard **100** may include a mushroom-shaped body **102.** The mushroom-shaped body **102** may include a first section **102-1** and a second section **102-2.** The first section **102-1** may have an upward-facing frustum shape. Further, the second section **102-2** may have a downward-facing frustum shape.

The mushroom-shaped body **102** may be made of Polyether ether ketone (PEEK) plastic, chosen for its high durability, ability to withstand operating temperatures up to 260°C, and a melting point of 343°C. PEEK makes the scratch protection guard **100** suitable for use in environments where temperature regulation is critical, such as data centers and telecom equipment assemblies. In different implementations, based on requirement, the mushroom-shaped body **102** may be made of rubber, plastic, polyurethane, silicone, thermoplastic elastomers (TPE), polyvinyl chloride (PVC), polytetrafluoroethylene (PTFE), polyethylene (PE), polypropylene (PP), and acrylonitrile butadiene styrene (ABS).

The scratch protection guard **100** may further include a metallic contact element **104.** The metallic contact element **104** may have an inverted T-shape including two continuous portions, a first portion **104-1** and a second portion **104-2.** The first portion **104-1** may be present in center of the first section **102-1** and the second portion **104-2** may be present between the first section **102-1** and the second section **102-2.**

The metallic contact element **104** may be made of a conductive material including, but not limited to, copper, silver, nickel, zinc, iron, steel, or aluminum. In some implementations, the metallic contact element **104** may be formed as a curved member, planar member, cantilevered member, spring-like member, segmented member, or multi-contact structure configured to engage both the sliding component **300** and the housing shelf **200.** The first portion **104-1** and the second portion **104-2** may be integrally formed or may be formed as separate conductive elements electrically coupled to one another.

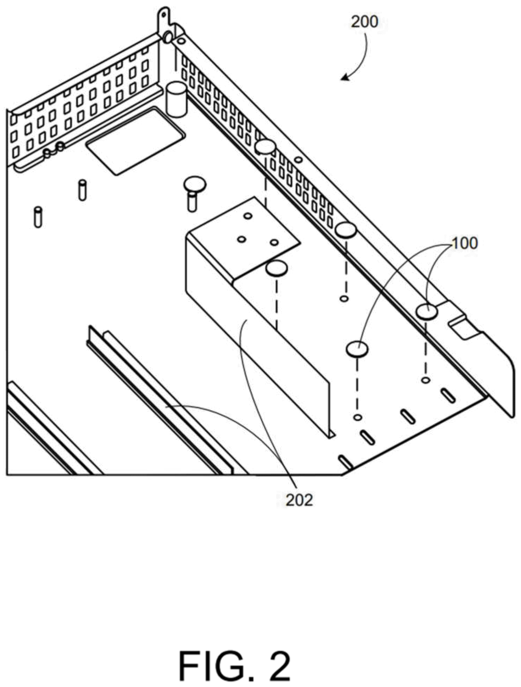

**FIG. 2** illustrates a perspective view of a housing shelf **200** having the scratch protection guard **100** installed. The housing shelf **200** may include partitioning elements **202.** A pair of the partitioning elements **202** define multiple regions for placement of a sliding component **300.** The partitioning elements **202** may be made up of a metallic element. After placement, a gap/tolerance remains between the partitioning elements **202** and the sliding component **300.**

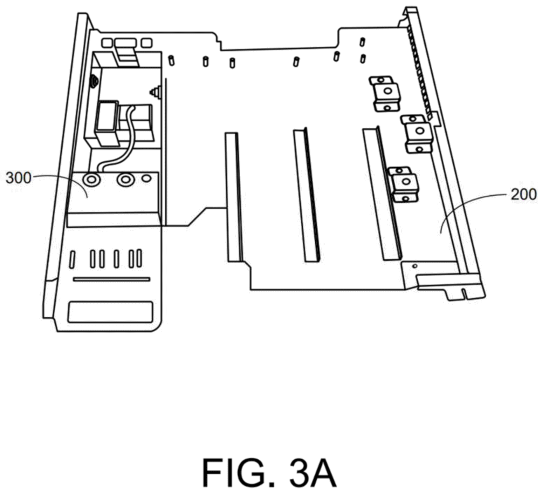

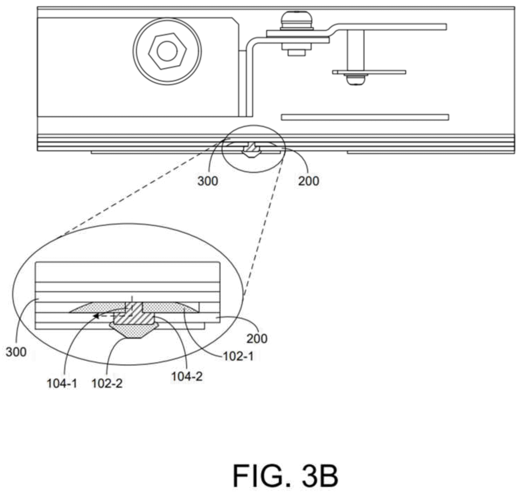

When the scratch protection guard **100** is attached to the housing shelf **200,** the first section **102-1** of the mushroom-shaped body **102** may rest over a surface of the housing shelf **200** and the second section **102-2** may reside beneath the surface of the housing shelf **200.** The first section **102-1** prevents direct contact between the sliding component **300** (as shown in **FIGS. 3A** and **3B**) and the housing shelf **200,** thereby minimizing surface scratches. The frustum shape of first section **102-1** offers uniform distributing forces when the sliding component **300** moves over the scratch protection guard **100.**

In one implementation, the scratch protection guard **100** may be retained within an opening, slot, or aperture formed in the housing shelf **200** by an interference fit, press fit, snap fit, frictional engagement, or elastic deformation of the second section **102-2.** In other implementations, the scratch protection guard **100** may be secured using adhesive bonding or mechanical fastening.

Further, the first portion **104-1** of the metallic contact element **104** may be in direct contact with the sliding component **300** and the second portion **104-2** may be in direct contact with the housing shelf **200** to provide an electrical grounding path between the sliding component **300** and the housing shelf **200,** as illustrated by a dotted arrow in **FIG. 3B****.** The electrical grounding path mitigates EMI issues by facilitating electrical grounding from the sliding component **300** to the housing shelf **200,** while preventing physical damage to the housing shelf.

The metallic contact element **104** may be configured to maintain electrical contact during relative sliding movement of the sliding component **300** with respect to the housing shelf **200.** Elastic deformation of the mushroom-shaped body **102** and/or the metallic contact element **104** enables continued electrical continuity while permitting relative motion. In some implementations, a plurality of scratch protection guards **100** may be distributed along the housing shelf **200** to support the sliding component **300** at multiple contact locations.

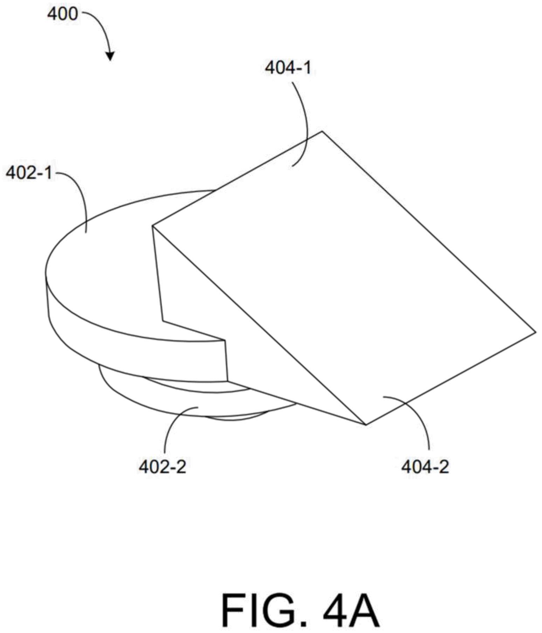

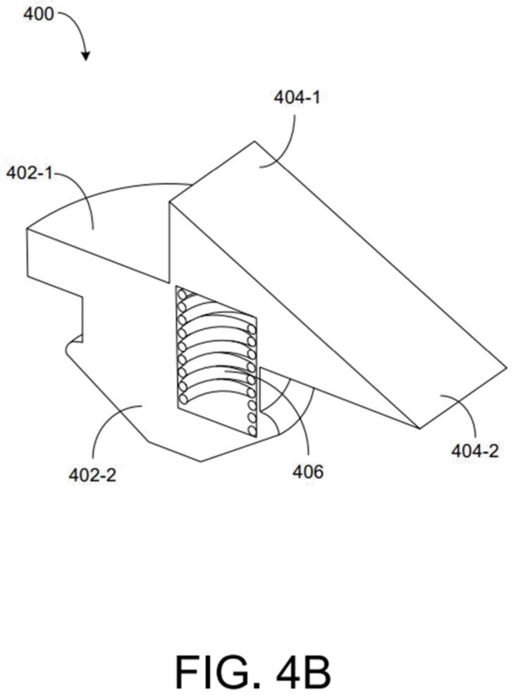

**FIGS. 4A** and **4B** illustrate a perspective view and a sectional view of a scratch protection guard **400** respectively. The scratch protection guard **400** may include a mushroom-shaped body **402.** The mushroom-shaped body **402** may include a first section **402-1** and a second section **402-2.** The first section **402-1** may have a disc shape. The second section **402-2** may be present as a ring.

The mushroom-shaped body **402** may be made of Polyether ether ketone (PEEK) plastic, chosen for its high durability, ability to withstand operating temperatures up to 260°C, and a melting point of 343°C. PEEK makes the scratch protection guard **400** suitable for use in environments where temperature regulation is critical, such as data centers and telecom equipment assemblies. In different implementations, based on requirement, the mushroom-shaped body **402** may be made of rubber, plastic, polyurethane, silicone, thermoplastic elastomers (TPE), polyvinyl chloride (PVC), polytetrafluoroethylene (PTFE), polyethylene (PE), polypropylene (PP), and acrylonitrile butadiene styrene (ABS).

The first section **402-1** of the mushroom-shaped body **402** rests over a surface of a housing shelf to prevent direct contact between a sliding component and the housing shelf, thereby minimizing surface scratches. The disc shape of the first section **402-1** may enhance structural stability of the mushroom-shaped body **402** by distributing forces more evenly when the sliding component moves over the scratch protection guard **100.** Further, the first section **402-1** and the second section **402-2** secure the scratch protection guard **400** with the housing shelf. The second section **402-2** may elastically deform during installation to retain the scratch protection guard **400** within the housing shelf **200** through interference or frictional engagement.

Now referring back to **FIG. 2****,** the housing shelf **200** may include partitioning elements **202.** A pair of the partitioning elements **202** define multiple regions for placement of a sliding component **300.** The partitioning elements **202** may be made up of a metallic element. After placement, a gap/tolerance remains between the partitioning elements **202** and the sliding component **300.**

The scratch protection guard **400** may further include a metallic contact element **404** to facilitate electrical grounding between the sliding component **300** and the housing shelf **200.** The metallic contact element **404** may be present as a triangular wedge. Further, the metallic contact element **404** includes two continuous portions, a first portion **404-1** and a second portion **404-2.** The first portion **404-1** may be placed partially over the first section **402-1** of the mushroom-shaped body **402.** Furthermore, the second portion **404-2** may be partially around the first section **402-1** of the mushroom-shaped body **402.** The first portion **404-1** of the metallic contact element **404** may be attached to the mushroom-shaped body **402** using a spring **406** (as shown in **FIG. 4B**).

The metallic contact element **404** may be made of one or more conductive materials including but not limited to, copper, silver, nickel, zinc, iron, steel, or aluminum.

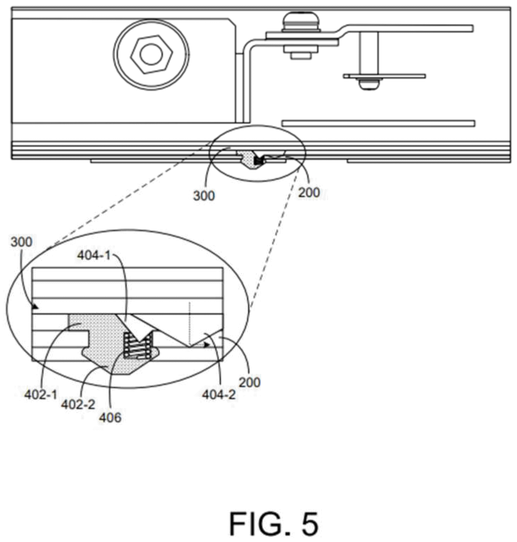

When the spring **406** is at a relaxed position, the second portion **404-2** of the metallic contact element **404** may not be in contact with the housing shelf **200.** As the sliding component **300** slides over the scratch protection guard **400** in the housing shelf **200,** the sliding component **300** makes contact with the first portion **404-1,** as illustrated in **FIG. 5****.**

Now again referring to **FIG. 5****,** due to sliding of the sliding component **300,** the first portion **404-1** may be pushed and the metallic contact element **404** may tilt downwards to make contact of the second portion **404-2** with the housing shelf **200,** due to compression on the spring **406.** The contact between the metallic contact element **404,** the housing shelf **200** and the sliding component **300** provides an electrical grounding path between the sliding component **300** and the housing shelf **200,** as illustrated by a dotted arrow in **FIG. 5****.** The electrical grounding path mitigates EMI issues by facilitating electrical grounding from the sliding component **300** to the housing shelf **200,** while preventing physical damage to the housing shelf. The spring **406** may be selected to provide a predetermined biasing force such that electrical contact is established only upon engagement by the sliding component **300,** while permitting disengagement when the sliding component **300** is removed.

The scratch protection guard **100, 400** disclosed provides several advantages. The scratch protection guard **100, 400** prevents surface damage by interposing a mushroom-shaped body between a sliding component and a housing shelf, thereby eliminating direct contact between the sliding component and the housing shelf during insertion, removal, and sliding movement. Additionally, the scratch protection guard **100, 400** ensures reliable grounding by integrating a conductive metallic contact element with the mushroom-shaped body, wherein the metallic contact element maintains an electrical connection between the sliding component and the housing shelf during relative movement, thereby facilitating continuous electrical grounding of the sliding component.

The methods, systems, devices, graphs, and/or tables discussed herein are examples. Various embodiments may omit, substitute, or add various procedures or components as appropriate. For instance, in alternative embodiments, the methods may be performed in an order different from that described, and/or various stages may be added, omitted, and/or combined. Also, features described with respect to certain embodiments may be combined in various other embodiments. Different aspects and elements of the embodiments may be combined in a similar manner. Also, technology evolves and, thus, many of the elements are examples and do not limit the scope of the disclosure or claims. Additionally, the techniques discussed herein may provide differing results with different types of context awareness classifiers.

Unless defined otherwise, all technical and scientific terms used herein have the same meaning as commonly or conventionally understood. As used herein, the articles "a" and "an" refer to one or to more than one (i.e., to at least one) of the grammatical object of the article. By way of example, "an element" means one element or more than one element. "About" and/or "approximately" as used herein when referring to a measurable value such as an amount, a temporal duration, and the like, encompasses variations of +20% or +10%, +5%, or +0.1% from the specified value, as such variations are appropriate to in the context of the systems, devices, circuits, methods, and other implementations described herein. "Substantially" as used herein when referring to a measurable value such as an amount, a temporal duration, a physical attribute (such as frequency), and the like, also encompasses variations of ±20% or ±10%, ±5%, or ±0.1% from the specified value, as such variations are appropriate to in the context of the systems, devices, circuits, methods, and other implementations described herein.

As used herein, including in the claims, "and" as used in a list of items prefaced by "at least one of" or "one or more of" indicates that any combination of the listed items may be used. For example, a list of "at least one of A, B, and C" includes any of the combinations A or B or C or AB or AC or BC and/or ABC (i.e., A and B and C). Furthermore, to the extent more than one occurrence or use of the items A, B, or C is possible, multiple uses of A, B, and/or C may form part of the contemplated combinations. For example, a list of "at least one of A, B, and C" may also include AA, AAB, AAA, BB, etc.

While illustrative and presently preferred embodiments of the disclosed systems, methods, and/or machine-readable media have been described in detail herein, it is to be understood that the inventive concepts may be otherwise variously embodied and employed, and that the appended claims are intended to be construed to include such variations, except as limited by the prior art. While the principles of the disclosure have been described above in connection with specific apparatuses and methods, it is to be clearly understood that this description is made only by way of example and not as a limitation on the scope of the disclosure.

## Claims

1. A scratch protection guard (100, 400), comprises:
a mushroom-shaped body (102, 402) to fit in a housing shelf, wherein a section of the mushroom-shaped body (102, 402) surfaces on the housing shelf to prevent direct contact between the housing shelf and a sliding component made to slide over the housing shelf; and
a metallic contact element (104, 404) integrated with the mushroom-shaped body, wherein the metallic contact element (104, 404) comprises a first portion (104-1, 404-1) and a second portion (104-2, 404-2), wherein the first portion (104-1, 404-1) engages with the sliding component and the second portion (104-2, 404-2) engages with the housing shelf to facilitate electrical grounding for the sliding component.

2. The scratch protection guard (100, 400) as claimed in claim 1, wherein the mushroom-shaped body (102, 402) is configured to be retained in an opening formed in the housing shelf by at least one of an interference fit, press fit, snap fit, frictional engagement, or elastic deformation.

3. The scratch protection guard (100) as claimed in claim 1 or 2, wherein the mushroom-shaped body (102) comprises a first section (102-1) configured to surface on the housing shelf and a second section (102-2) configured to be received beneath the housing shelf, and wherein the first section (102-1) has an upward-facing frustum shape and the second section (102-2) has a downward-facing frustum shape.

4. The scratch protection guard (100) as claimed in any preceding claim, wherein the metallic contact element (104) is integrally formed as a single continuous conductive element.

5. The scratch protection guard (100) as claimed in claim 4, wherein the metallic contact element (104) is configured to maintain electrical contact between the sliding component and the housing shelf during relative sliding movement of the sliding component, and wherein the metallic contact element (104) is configured to provide at least one of point contact, line contact, or surface contact with the sliding component.

6. The scratch protection guard (100) as claimed in any preceding claim, wherein the metallic contact element (104) is insert-molded within the mushroom-shaped body (102).

7. The scratch protection guard (400) as claimed in any preceding claim, wherein the metallic contact element (404) is movable relative to the mushroom-shaped body (402).

8. The scratch protection guard (400) as claimed in any preceding claim, wherein the metallic contact element (404) is coupled to the mushroom-shaped body (403) by a spring (406) configured to bias the metallic contact element (404) toward the sliding component.
